# EUROPEAN PATENT APPLICATION

(11) **EP 4 290 584 A1**
(43) Date of publication of application: **13.12.2023**
(21) Application number: 22762425.1
(22) Date of filing: 24.02.2022
(51) Int. Cl.: H01L 29/739, H01L 29/06, H01L 21/331, H01L 29/423, H01L 29/417

(54) **SEMICONDUCTOR DEVICE AND MANUFACTURING METHOD THEREFOR, AND ELECTRONIC DEVICE**

(30) Priority: 02.03.2021 CN 202110228786
(71) Applicant: Huawei Technologies Co., Ltd., Shenzhen, Guangdong 518129 (CN)
(72) Inventor: YANG, Wentao, Shenzhen, Guangdong 518129 (CN); WANG, Kang, Shenzhen, Guangdong 518129 (CN); SONG, Chaofan, Shenzhen, Guangdong 518129 (CN); WANG, Lianghao, Shenzhen, Guangdong 518129 (CN); ZHAO, Qian, Shenzhen, Guangdong 518129 (CN); DAI, Loucheng, Shenzhen, Guangdong 518129 (CN); HOU, Zhaozheng, Shenzhen, Guangdong 518129 (CN); HUANG, Boning, Shenzhen, Guangdong 518129 (CN)
(74) Representative: Goddar, Heinz J.
(86) International application number: PCT/CN2022/077597
(87) International publication number: WO 2022/183959

(57) **Abstract**

This application provides a semiconductor device, a method for preparing the semiconductor device, and an electronic device. The semiconductor device includes a drift region, a first electrode structure, and a second electrode structure, and the first electrode structure and the second electrode structure are located on a same side of the drift region. The first electrode structure includes a first insulation layer and a first electrode. The first insulation layer is located on a periphery of the first electrode. The second electrode structure includes a second insulation layer and a second electrode. The second insulation layer is located on a periphery of the second electrode. A buffer structure is disposed between the first electrode and the second electrode, and the buffer structure is configured to increase accumulation of carriers in the drift region when the semiconductor device is turned on. In this application, the buffer structure is disposed between the first electrode and the second electrode, so that flow of carriers stored in the drift region is buffered when the semiconductor device is turned on. This improves a concentration of carriers in the drift region, and helps reduce turn-on voltage drop of the semiconductor device.

## Description

This application claims priority to Chinese Patent Application No. 202110228786.2, filed with the China National Intellectual Property Administration on March 2, 2021 and entitled "SEMICONDUCTOR DEVICE, METHOD FOR PREPARING SAME, AND ELECTRONIC DEVICE", which is incorporated herein by reference in its entirety.

### TECHNICAL FIELD

This application relates to the field of semiconductor technologies, and in particular, to a semiconductor device, a method for preparing the semiconductor device, and an electronic device.

### BACKGROUND

As a core device of a power electronics technology, a semiconductor device is widely applied to various high-power fields such as transportation, communications, home appliances, and aerospace because of its advantages such as simple gate driving, low driving power, low input impedance, and good stability.

Currently, a turn-on voltage drop problem of the semiconductor device is a key factor of limiting performance optimization of the semiconductor device. Large turn-on voltage drop of the semiconductor device results in increased loss of the semiconductor device during operation, which is not conducive to performance optimization of the semiconductor device.

Therefore, how to reduce turn-on voltage drop of a semiconductor device to improve performance of the semiconductor device should be a research and development direction of the industry.

### SUMMARY

This application provides a semiconductor device, a method for preparing the semiconductor device, and an electronic device, to reduce turn-on voltage drop of the semiconductor device, so as to optimize performance of the semiconductor device.

According to a first aspect, this application provides a semiconductor device, including a drift region, a first electrode structure, and a second electrode structure. The first electrode structure and the second electrode structure are located on a same side of the drift region. The semiconductor device is usually a structure formed by stacking a plurality of functional layers. That the first electrode structure and the second electrode structure are located on a same side of the drift region means that in a stacking direction of the plurality of functional layers, the drift region is provided with a top and a bottom that are disposed opposite to each other, and electrons flow from the top of the drift region to the bottom of the drift region, holes flow from the bottom of the drift region to the top of the drift region, and both the first electrode structure and the second electrode structure are disposed on the top of the drift region. The first electrode structure includes a first insulation layer and a first electrode, and the first insulation layer is located on a periphery of the first electrode. The second electrode structure includes a second insulation layer and a second electrode, and the second insulation layer is located on a periphery of the second electrode. A buffer structure is disposed between the first electrode and the second electrode, and the buffer structure is configured to increase accumulation of carriers in the drift region when the semiconductor device is turned on. It may be understood that the carriers may be electrons, or the carriers may be holes.

That the buffer structure is configured to increase accumulation of carriers in the drift region when the semiconductor device is turned on may be understood as: When the semiconductor device is turned on, carriers stored in the drift region may pass through the buffer structure but does not all pass through the buffer structure in a centralized manner, and the buffer structure buffers passing of carriers. That is, accumulation of carriers in the drift region is increased. Alternatively, that the buffer structure is configured to increase accumulation of carriers in the drift region when the semiconductor device is turned on may be understood as: When the semiconductor device is turned on, carriers stored in the drift region do not pass through the buffer structure, that is, the buffer structure blocks the flow of carriers between the first electrode and the second electrode. This excludes one flow path of carriers, and reduces the flow of carriers stored in the drift region. That is, the buffer structure increases accumulation of carriers in the drift region.

In this application, the buffer structure is disposed between the first electrode and the second electrode, so that the flow of carriers stored in the drift region is buffered when the semiconductor device is turned on, that is, accumulation of carriers in the drift region is increased, thereby helping reduce the turn-on voltage drop of the semiconductor device. Specifically, in a process of turning on the semiconductor device, holes and electrons accumulate in the drift region. Therefore, the drift region stores holes and electrons. Holes stored in the drift region need to continuously flow to the top of the drift region, and further to pass through other functional layers disposed in a stacked manner on the top of the drift region, to form a current. However, after a large quantity of holes flow from the drift region to other functional layers, holes stored in the drift region decrease. This increases the turn-on voltage drop of the semiconductor device. The buffer structure is disposed between the first electrode and the second electrode, that is, the buffer structure is disposed on the top of the drift region. In this way, when the semiconductor device is turned on, the buffer structure may buffer the flow of holes stored in the drift region, so as to increase accumulation of carriers stored in the drift region, reduce the turn-on voltage drop of the semiconductor device, and optimize performance of the semiconductor device.

It may be understood that, in a case in which carriers stored in the drift region may pass through the buffer structure but do not all pass through the buffer structure in a centralized manner, when the semiconductor device is turned on, the buffer structure buffers the flow of carriers stored in the drift region of the semiconductor device, increases a concentration of carriers in the drift region, and helps reduce the turn-on voltage drop of the semiconductor device. When the semiconductor device is turned off, carriers may pass through the buffer structure. This accelerates extraction of carriers, and helps improve a turn-off speed of the semiconductor device, and reduce turn-off loss of the semiconductor device.

In a possible implementation, the semiconductor device includes an emitter, and the first electrode structure and the second electrode structure are located between the emitter and the drift region and are spaced apart. A first channel structure is disposed between the first electrode structure and the second electrode structure, and the first channel structure is connected between the emitter and the drift region. The first channel structure can increase accumulation of carriers in the drift region when the semiconductor device is turned on. The first channel structure, the first insulation layer, and the second insulation layer jointly form the buffer structure. When the first electrode structure and the second electrode structure are spaced apart, after the semiconductor device is turned on, carriers stored in the drift region may pass through the buffer structure (that is, carriers stored in the drift region may pass between the first electrode and the second electrode) but do not all pass through the buffer structure in a centralized manner. The buffer structure buffers the flow of carriers, increases a concentration of carriers stored in the drift region, and helps reduce the turn-on voltage drop of the semiconductor device. When the semiconductor device is turned off, carriers may pass through the first channel structure. This accelerates extraction of carriers, helps improve a turn-off speed of the semiconductor device, and reduces turn-off loss of the semiconductor device.

In a possible implementation, the first channel structure includes a buffer layer and a charge layer disposed in a stacked manner, the buffer layer is located between the drift region and the charge layer, the charge layer is a P-type semiconductor, the buffer layer is an N-type semiconductor, and the buffer layer, the first insulation layer, and the second insulation layer jointly form the buffer structure. The buffer layer is in contact with the first insulation layer, and the buffer layer is in contact with the second insulation layer, that is, the buffer layer is located between the first electrode structure and the second electrode structure. When the buffer layer is located on a side on which a bottom of the first electrode and a bottom of the second electrode are located, an electric field at a bottom of the buffer layer is greater than an electric field at the bottom of the first electrode and an electric field at the bottom of the second electrode, and an electric field is mainly concentrated at the bottom of the buffer layer, and the buffer layer is prone to a breakdown. In this embodiment, the buffer layer is disposed between the first electrode and the second electrode, the electric field at the bottom of the first electrode and the electric field at the bottom of the second electrode are greater than the electric field at the bottom of the buffer layer, and an electric field is mainly concentrated at the bottom of the first electrode and the bottom of the second electrode. In this way, the buffer layer is not prone to a breakdown.

When the semiconductor device is turned on, the buffer structure is mainly configured to buffer the flow of holes stored in the drift region. Holes are generated by a P-type semiconductor, and the flow of holes in an N-type semiconductor is hindered. Therefore, to buffer the flow of holes, the buffer layer is set as an N-type semiconductor. In this way, the flow of holes can be effectively buffered, to reduce the turn-on voltage drop of the semiconductor device and optimize performance of the semiconductor device. An impurity doping concentration of the buffer layer is adjustable. Changing the impurity doping concentration of the buffer layer can change a threshold voltage of the first channel structure between the first electrode structure and the second electrode structure. The change of the threshold voltage may adjust an extraction speed of holes, to improve a compromise between the turn-on voltage drop and the turn-off loss of the semiconductor device.

In a possible implementation, the first channel structure further includes a contact layer. The contact layer is located between the charge layer and the emitter. An impurity doping concentration of the contact layer is greater than an impurity doping concentration of the charge layer, and the contact layer is in contact with the emitter. The impurity doping density of the charge layer is relatively low, and the charge layer is in direct contact with the emitter. This causes a relatively large contact resistance. In this embodiment, the impurity doping density of the contact layer is set to be greater than the impurity doping density of the charge layer. In this way, when the contact layer is in contact with the emitter, a contact resistance can be reduced, and switching loss, function loss, and the like of the semiconductor device can be reduced.

In a possible implementation, the first electrode is electrically connected to the emitter, and the second electrode is insulated from the emitter. Specifically, the first electrode includes a first bottom and a first top that are disposed opposite to each other, and a first side portion and a second side portion that are disposed opposite to each other. The first insulation layer surrounds the first side portion, the first bottom, and the second side portion, and the first top is electrically connected to the emitter. The second electrode includes a second bottom and a second top that are disposed opposite to each other, and a third side portion and a fourth side portion that are disposed opposite to each other. The second insulation layer surrounds the third side portion, the second bottom, and the fourth side portion, and the second top is insulated from the emitter. The first bottom of the first electrode is disposed adjacent to the drift region, and the first top of the first electrode is in contact with the emitter and is electrically connected to the emitter. That the first top of the first electrode is electrically connected to the emitter may be understood as: The first top of the first electrode is not insulated from the emitter. The first electrode and the emitter may have an equal potential. This helps reduce a Miller capacitance of the semiconductor device, improve a switching speed of the semiconductor device, and reduce switching loss of the semiconductor device. The second bottom of the second electrode is disposed adjacent to the drift region. That the second top of the second electrode is insulated from the emitter means that the second top of the second electrode is electrically isolated from the emitter. Specifically, an insulation dielectric layer may be disposed between the second top of the second electrode and the emitter, to implement insulation between the second electrode and the emitter. In addition, the second top of the second electrode may alternatively be insulated from the emitter in another manner.

In a possible implementation, the first electrode structure is in contact with the second electrode structure, and a part of the first insulation layer and a part of the second insulation layer are interconnected together between the first electrode and the second electrode, to form the buffer structure. In other words, the first insulation layer is in contact with the second insulation layer. A side that is of the first electrode and that is away from the second electrode is the first side portion, and a side that is of the first electrode and that is adjacent to the second electrode is the second side portion. A side that is of the second electrode and that is away from the first electrode is the third side portion, and a side that is of the second electrode and that is adjacent to the first electrode is the fourth side portion. The part of the first insulation layer means a part that is of the first insulation layer and that is in contact with the second side portion, and the part of the second insulation layer means a part that is of the second insulation layer and that is in contact with the fourth side portion. In this implementation, the first insulation layer is in contact with the second insulation layer, and the buffer structure blocks the carrier from passing between the first electrode and the second electrode, that is, carriers stored in the drift region do not pass between the first electrode and the second electrode. This excludes one flow path of carriers, and reduces the flow of carriers stored in the drift region. That is, the buffer structure buffers the flow of carriers stored in the drift region. The first insulation layer is in contact with the second insulation layer, so that a spacing between the first electrode structure and the second electrode structure is zero. This helps reduce a gate capacitance, improve a switching speed of the semiconductor device, and meanwhile reduce electric field concentration at the bottom of the second electrode structure, thereby improving reliability of the semiconductor device.

In a possible implementation, the drift region includes a top and a bottom that are disposed opposite to each other, and both the first electrode structure and the second electrode structure are located on the top. The first electrode structure includes a first bottom surface, and the second electrode structure includes a second bottom surface. Both the first bottom surface and the second bottom surface are connected to the top of the drift region, and a spacing between the first bottom surface and the bottom is less than a spacing between the second bottom surface and the bottom. It may be understood that the first bottom surface and the second bottom surface may be in direct contact with and connected to and the top of the drift region, or may be indirectly connected to the top of the drift region. A side on which the top of the drift region is located is a front side of the semiconductor device, and a side on which the bottom of the drift region is located is a back side of the semiconductor device. Electric field strength gradually increases from the front side of the semiconductor device to the back side of the semiconductor device, that is, the electric field strength gradually increases from the top of the drift region to the bottom of the drift region. The spacing between the first bottom surface and the bottom is limited to be less than the spacing between the second bottom surface and the bottom, so that electric field strength at the bottom of the first electrode structure is greater than electric field strength at the bottom of the second electrode structure. In this way, an electric field is mainly concentrated at the bottom of the first electrode structure, damage to the second electrode structure can be avoided. If the spacing between the first bottom surface and the bottom is equal to the spacing between the second bottom surface and the bottom, the electric field strength at the bottom of the first electrode structure is the same as the electric field strength at the bottom of the second electrode structure. In this way, if a breakdown occurs, both the first electrode structure and the second electrode structure are damaged, increasing a degree of damage to the semiconductor device.

In a possible implementation, the buffer structure is in contact with the drift region. The contact between the buffer structure and the drift region can effectively buffer the flow of carriers stored in the drift region when the semiconductor device is turned on. This improves concentration of carriers in the drift region, and reduces the turn-on voltage drop of the semiconductor device. In another implementation, the buffer structure may not be in contact with the drift region, that is, another structure may be further disposed between the buffer structure and the drift region.

In a possible implementation, there are two first electrode structures, the two first electrode structures are spaced apart, and the second electrode structures are located between two first electrode structures. There are at least two second electrode structures, a size of the buffer structure in a first direction is less than a spacing between two adjacent second electrode structures, and the first direction is a direction in which the first electrode structure and the second electrode structure are arranged. When there are two or more second electrode structures, the size of the buffer structure in the first direction is set to be less than a spacing between adjacent second electrode structures, so as to reduce a gate capacitance, improve a switching speed can be improved, reduce switching loss, and optimize performance of the semiconductor device. Specifically, the quantity of second electrode structures may be two, three, four, five, six, or the like. This is not limited in this application. It may be understood that, in another implementation, there may be one second electrode structure.

In a possible implementation, the semiconductor device includes a floating region, and in a first direction, the floating region, the first electrode, the buffer structure, and the second electrode are arranged in sequence. That is, the first electrode structure is located between the floating region and the second electrode structure. Specifically, the floating region, the first electrode, the buffer structure, and the second electrode are all located on the top of the drift region. The floating region is in a floating state, and electrons and holes are aggregated at the bottom of the floating region, that is, electrons and holes are aggregated in the drift region. A large quantity of electrons and holes are stored in the drift region, thereby improving a concentration of electrons and holes in the drift region, and helping reduce turn-on voltage drop of the semiconductor device. The first electrode structure in this embodiment is located between the floating region and the second electrode structure, that is, the first electrode structure isolates the floating region from the second electrode structure, to avoid an oscillation problem of the second electrode structure caused by the floating region (the oscillation problem of the second electrode structure means that if there is no first electrode structure, the floating region is in direct contact with the second electrode structure, and when the semiconductor device is turned on, a potential change in the floating region is caused due to accumulation of holes at the bottom of the floating region and is fed back to the second electrode structure through a gate capacitor; consequently, oscillation of the second electrode structure occurs when the semiconductor device is turned on, deteriorating an electromagnetic interference feature of the semiconductor device, and affecting reliability of the semiconductor device). In addition, because the first electrode structure and the emitter have an equal potential, thereby reducing a Miller capacitance of the semiconductor device, improving a switching speed of the semiconductor device, and reducing switching loss of the semiconductor device.

In a possible implementation, the first electrode structure includes a first top surface and a first bottom surface that are disposed opposite to each other, the first top surface is disposed away from the drift region, and the floating region covers the first bottom surface. That is, a part of the floating region is disposed between the bottom of the first electrode structure and the drift region, and the first bottom surface is in contact with the floating region. The floating region covers the first bottom surface of the first electrode structure, so that electric field concentration at the bottom of the first electrode structure can be alleviated, thereby avoiding a breakdown of the bottom of the first electrode structure, and improving reliability of the semiconductor device. In addition, in this application, a size of the buffer structure in a first direction may be set to be less than a spacing between two adjacent second electrode structures, that is, a spacing between the first electrode structure and the second electrode structure that are adjacent to each other may be very small, and the second electrode structure is disposed adjacent to the first electrode structure. In this way, the first bottom surface of the first electrode structure covered by the floating region can alleviate electric field concentration at the bottom of the first electrode structure, and may further alleviate electric field concentration at the bottom of the second electrode structure adjacent to the first electrode structure, thereby avoiding a breakdown at the bottom of the second electrode structure, and improving reliability of the semiconductor device.

In a possible implementation, there are two floating regions that are distributed on a same side of the drift region at an interval, and the two floating regions are respectively a first floating region and a second floating region. The second electrode structure is located between the first floating region and the second floating region. The first electrode structure is disposed at an edge, facing the second floating region, of the first floating region, and the first electrode structure is disposed at an edge, facing the first floating region, of the second floating region. The first electrode structure isolates the first floating region from the second electrode structure, and the first electrode structure isolates the second floating region from the second electrode structure. It may be understood that the second electrode structure is located between the two first electrode structures. The quantity of second electrode structures may be one, two, three, four, five, six, or the like. This is not limited in this application. When there are a plurality of second electrode structures, the buffer structure is located between the first electrode structure and the second electrode structure that are adjacent to each other.

In a possible implementation, the floating region includes at least two floating portions, the at least two floating portions are spaced apart, and a third electrode structure is disposed between adjacent floating portions. The third electrode structure includes a third insulation layer and a third electrode, and the third insulation layer is located on a periphery of the third electrode. Performance, a material, a structure, and the like of the third insulation layer are the same as those of the first insulation layer, and performance, a material, a structure, and the like of the third electrode are the same as those of the first electrode. That is, the third electrode structure and the first electrode structure have the same performance, material, structure and the like, but are located at different positions. Specifically, the first electrode structure is located on an edge of the floating region, and the third electrode structure is located between two adjacent floating portions. Therefore, this may be understood as: In this application, a plurality of first electrode structures may be disposed, but for differentiation purposes, an electrode structure located between two adjacent floating portions is referred to as the third electrode structure. The third electrode structure and the emitter have an equal potential. This helps reduce a Miller capacitance of the semiconductor device, improve a switching speed of the semiconductor device, and reduce switching loss of the semiconductor device. In this embodiment, the third electrode structure is disposed, to reduce a gate capacitance, and improve a switching speed. The quantity of third electrode structures may be one, two, three, four, five, six, or the like. This is not limited in this application.

According to a second aspect, this application provides a method for preparing a semiconductor device, including: providing a silicon wafer, where the silicon wafer includes a drift region; performing etching processing on one side of the drift region to form a first groove and a second groove that are spaced apart; performing oxidation processing on a wall of the first groove to form a first insulation layer, and performing oxidation processing on a wall of the second groove to form a second insulation layer; depositing a first electrode in the first groove, where the first insulation layer is located on a periphery of the first electrode, and depositing a second electrode in the second groove, where the second insulation layer is located on a periphery of the second electrode; and forming a buffer structure between the first electrode and the second electrode, so that when the semiconductor device is turned on, the buffer structure is configured to increase accumulation of carriers in the drift region.

In this application, the buffer structure is formed between the first electrode and the second electrode, so that when the semiconductor device is turned on, the flow of carriers stored in the drift region can be effectively buffered, and accumulation of carriers in the drift region can be increased. This helps reduce turn-on voltage drop of the semiconductor device and optimize performance of the semiconductor device.

In a possible implementation, in a process of preparing the first insulation layer and the second insulation layer, the first insulation layer and the second insulation layer are spaced apart. Before the forming a first groove and a second groove, the method further includes: performing ion injection processing on the drift region to inject an N-type impurity so as to form a buffer layer, where the buffer layer is located between the first insulation layer and the second insulation layer, and the buffer layer, the first insulation layer, and the second insulation layer jointly form the buffer structure. In this embodiment, the first insulation layer is not in contact with the second insulation layer. In this way, a first channel structure (the first channel structure includes a buffer layer) may be disposed between the first electrode structure and the second electrode structure, and carriers may flow through the first channel structure, to add a path of extraction of holes when the semiconductor device is turned off, improve a turn-off speed of the semiconductor device, reduce turn-off loss of the semiconductor device, and improve a short-circuit feature of the semiconductor device. When the semiconductor device is turned on, the buffer structure is mainly configured to buffer the flow of holes stored in the drift region. Holes are generated by a P-type semiconductor, and the flow of holes in an N-type semiconductor is hindered. Therefore, to buffer the flow of holes, the buffer layer is set as an N-type semiconductor, that is, an N-type impurity is injected. In this way, the flow of holes stored in the drift region can be effectively buffered, to reduce the turn-on voltage drop of the semiconductor device and optimize performance of the semiconductor device.

In a possible implementation, ion injection processing is performed between the first insulation layer and the second insulation layer to inject a P-type impurity so as to form a charge layer, and ion injection processing is performed between the first insulation layer and the second insulation layer to inject a P-type impurity so as to form a contact layer. The charge layer is located between the buffer layer and the contact layer, and a P-type impurity doping concentration of the contact layer is greater than a P-type impurity doping concentration of the charge layer. The emitter is deposited on the contact layer, and the impurity doping density of the contact layer is relatively large. In this way, when the contact layer is in contact with the emitter, a contact resistance can be reduced, and switching loss, function loss, and the like of the semiconductor device can be reduced.

In a possible implementation, in a process of preparing the first insulation layer and the second insulation layer, the first insulation layer and the second insulation layer are interconnected together to form the buffer structure. The first insulation layer and the second insulation layer in this application are formed in different grooves (the first groove and the second groove), and the first electrode and the second electrode are located in different grooves. Compared with preparation of the first electrode and the second electrode in one groove, the first electrode is located in the first groove, and the second electrode is located in the second groove, that is, preparing the first electrode structure and the second electrode structure in different grooves can reduce process and preparation difficulty, and reduce possibility of generation of a defect in preparation.

In a possible implementation, a spacing between the first groove and the second groove is 0.1 µm to 0.3 µm. When oxidation processing is performed on the wall of the first groove, a side facing the second groove is oxidized to form the first insulation layer. When oxidation processing is performed on the wall of the second groove, a side facing the first groove is oxidized to form the second insulation layer. In this way, when the spacing between the first groove and the second groove is 0.1 µm to 0.3 µm, the formed first insulation layer and second insulation layer may be in contact with each other by controlling an oxidation process. When the spacing between the first groove and the second groove is less than 0.1 µm, a process for preparing the first groove and the second groove is difficult. When the spacing between the first groove and the second groove is greater than 0.3 µm, the spacing between the first groove and the second groove is too large. Consequently, it is difficult for the first insulation layer and the second insulation layer formed during oxidation to be in contact with each other.

According to a third aspect, this application provides an electronic device, including a first circuit, a second circuit, and the semiconductor device in any one of the foregoing implementations of the first aspect. The semiconductor device is electrically connected between the first circuit and the second circuit.

### BRIEF DESCRIPTION OF DRAWINGS

The following describes accompanying drawings used in embodiments of this application.
FIG. 1A is a schematic diagram of a structure of an electronic device according to an embodiment of this application;
FIG. 1B is a schematic diagram of a working principle of an electrode controller of an electric vehicle according to an embodiment of this application;
FIG. 2 is a schematic diagram of a structure of a semiconductor device according to an embodiment of this application;
FIG. 3 is an enlarged schematic diagram of a structure at H of the semiconductor structure shown in FIG. 2;
FIG. 4 is a schematic diagram of a structure of another semiconductor device according to an embodiment of this application;
FIG. 5 is a schematic diagram of a structure of another semiconductor device according to an embodiment of this application;
FIG. 6 is a schematic diagram of a structure of another semiconductor device according to an embodiment of this application;
FIG. 7 is a schematic diagram of a structure of another semiconductor device according to an embodiment of this application;
FIG. 8 is a schematic diagram of a structure of another semiconductor device according to an embodiment of this application;
FIG. 9 is a flowchart of preparing a semiconductor device according to an embodiment of this application;
FIG. 10 is a schematic diagram of a structure of a drift region according to an embodiment of this application;
FIG. 11 is a schematic diagram of a structure of a first floating region, a second floating region, and a channel region according to an embodiment of this application;
FIG. 12 is a schematic diagram of a structure of a first groove and a second groove according to an embodiment of this application;
FIG. 13 is a schematic diagram of a structure of a first electrode structure and a second electrode structure according to an embodiment of this application;
FIG. 14 is a schematic diagram of a structure of a semiconductor device according to an embodiment of this application;
FIG. 15 is a schematic diagram of a structure of another semiconductor device according to an embodiment of this application;
FIG. 16 is a schematic diagram of a structure of another semiconductor device according to an embodiment of this application;
FIG. 17 is a schematic diagram of another structure of a first groove and a second groove according to an embodiment of this application; and
FIG. 18 is a schematic diagram of another structure of a first electrode structure and a second electrode structure according to an embodiment of this application.

### DESCRIPTION OF EMBODIMENTS

The following clearly and completely describes technical solutions in embodiments of this application with reference to accompanying drawings in embodiments of this application. Apparently, the described embodiments are some but not all of the embodiments of this application. All other embodiments obtained by a person of ordinary skill in the art based on embodiments of this application without creative efforts shall fall within the protection scope of this application.

The orientation terms mentioned in embodiments of this application, such as "up", "down", "left", "right", "inside", and "outside", are merely directions with reference to the accompanying drawings. Therefore, the orientation terms are used to better and more clearly describe and understand embodiments of this application, instead of indicating or implying that a related apparatus or element must have a specific orientation and be constructed and operated in a specific orientation. Therefore, this shall not be understood as a limitation on embodiments of this application.

"N-type" in embodiments of this application indicates that electrons are dominant carriers, and "P-type" indicates that holes are dominant carriers. In addition, "+" denoted for "N" indicates that an impurity doping concentration thereof is higher than that of the N type, and "-" denoted for "N" indicates that an impurity doping concentration thereof is lower than that of the N type. "+" denoted for "P" indicates that an impurity doping concentration thereof is higher than that of the P type, and "-" denoted for "P" indicates that an impurity doping concentration thereof is lower than that of the P type. It should be noted that this application is described merely by using a cell structure of a semiconductor device as an example.

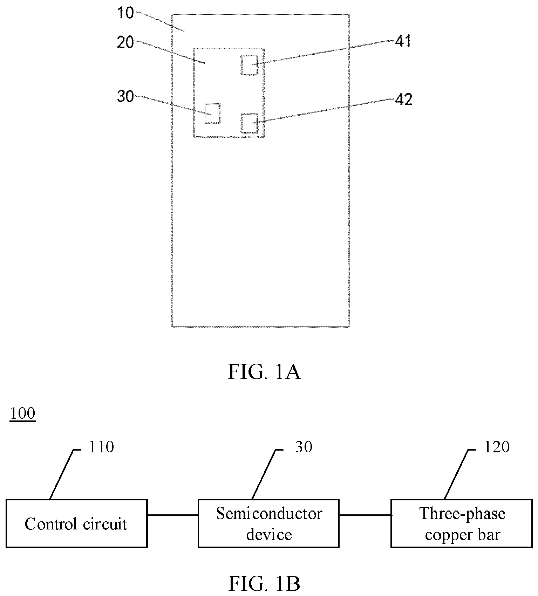

This application provides an electronic device. The electronic device 10 may be an inverter, an electric vehicle, or the like. As shown in FIG. 1A, FIG. 1A is a schematic diagram of a structure of an electronic device. The electronic device 10 includes a circuit board 20, a semiconductor device 30, a first circuit 41, and a second circuit 42. The semiconductor device 30 is installed on the circuit board 20. The semiconductor device 30 is electrically connected to the first circuit 41, and the semiconductor device 30 is electrically connected to the second circuit 42. That is, the semiconductor device 30 is electrically connected between the first circuit 41 and the second circuit 42, to implement a switch function or another function of the semiconductor device 30. As a core device of a power electronics technology, the semiconductor device 30 is widely applied to various high-power fields such as transportation, communications, home appliances, and aerospace because of its advantages such as simple gate driving, low driving power, low input impedance, and good stability.

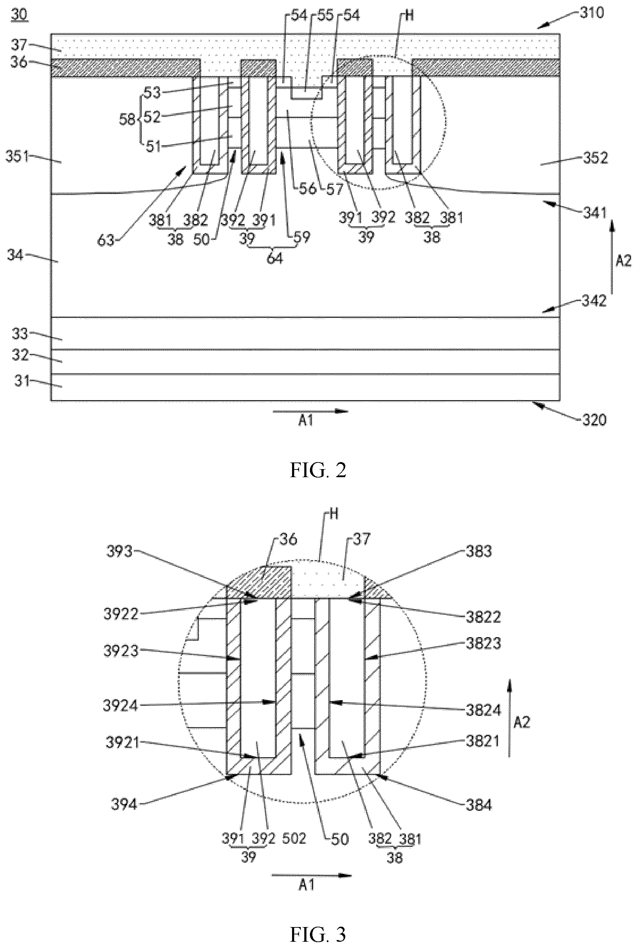

In a specific embodiment, refer to FIG. 1B. FIG. 1B is a schematic diagram of a working principle of a motor controller 100 of an electric vehicle. The electronic device 10 may be an electric vehicle, and a motor controller 100 is disposed in the electric vehicle. The motor controller 100 is an important signal and energy transfer element in the electric vehicle. The motor controller 100 may enable the electric vehicle to work based on a specified direction, speed, angle, and response time, to control a driving status such as a start/stop status, a moving speed, and a ramping force of the electric vehicle. The motor controller 100 includes a control circuit 110, a three-phase copper bar 120, and a semiconductor device 30. The control circuit 110, the three-phase copper bar 120, and the semiconductor device 30 are installed in a housing (not shown in FIG. 2). The control circuit 110 is a first circuit, the three-phase copper bar 120 is a second circuit, and the circuit board is not shown in FIG. 2. The semiconductor device 30 is mainly responsible for performing an inversion function of a current in the motor controller 100, and is a core device of a product. One side of the semiconductor device 30 is electrically connected to the control circuit 110, and one side of the semiconductor device 30 is electrically connected to the three-phase copper bar 120.

The semiconductor device 30 may be an insulated gate bipolar transistor (IGBT), or may be another semiconductor device such as an insulated gate field effect transistor. In this application, the IGBT is used as an example for description.

This application provides a semiconductor device and a method for preparing the semiconductor device. First, this application provides a semiconductor device 30. A specific structure of the semiconductor device 30 is as follows.

As shown in FIG. 2, FIG. 2 is a schematic diagram of a structure of a semiconductor device 30. The semiconductor device 30 includes a collector 31, a collector region 32, a field blocking layer 33, a drift region 34, a first floating region 351, a second floating region 352, an insulation dielectric layer 36, an emitter 37, a first electrode structure 38, a second electrode structure 39, a buffer layer 51, a charge layer 52, a contact layer 53, a first emission region 54, a second emission region 55, a base region 56, and a storage region 57. The first electrode structure 38 and the second electrode structure 39 are arranged along a first direction A1. The collector 31, the collector region 32, the field blocking layer 33, the drift region 34, the first floating region 351, the insulation dielectric layer 36, and the emitter 37 are disposed in sequence in a stacked manner along a second direction A2. The buffer layer 51, the charge region 52, and the contact region 53 are disposed in sequence in a stacked manner along the second direction A2. The storage region 57, the base region 56, the second emission region 55, and the first emission region 54 are disposed in sequence in a stacked manner along the second direction A2. It may be understood that the semiconductor device 30 is usually a structure formed by stacking a plurality of functional layers. "Disposed in sequence in a stacked manner" mentioned in this embodiment means that a plurality of functional layers are stacked along one direction, and the plurality of functional layers may be in direct contact with each other, or another structure may be disposed between adjacent functional layers. The semiconductor device 30 is provided with a front side 310 and a back side 320. Carriers are generated when the semiconductor device 30 is turned on. Carriers may include holes and electrons. Holes flow from the back side 320 of the semiconductor device 30 to the front side 310 of the semiconductor device 30, and electrons flow from the front side 310 of the semiconductor device 30 to the back side 320 of the semiconductor device 30.

In the second direction A2, the drift region 34 includes a top 341 and a bottom 342 that are disposed opposite to each other. Electrons having flowed to the drift region 34 flow from the top 341 of the drift region 34 to the bottom 342 of the drift region 34, and holes having flowed to the drift region 34 flow from the bottom 342 of the drift region 34 to the top 341 of drift region 34. It should be noted that the drift region 34 is equivalent to a path, electrons and holes may pass through the drift region 34, and can accumulate in the drift region 34. In this embodiment, that the drift region is an N-type semiconductor is used as an example for description. Specifically, the drift region may be an N-type semiconductor. In another implementation, the drift region may alternatively be a P-type semiconductor.

The first electrode structure 38 and the second electrode structure 39 are located on a same side of the drift region 34, and specifically, both the first electrode structure 38 and the second electrode structure 39 are located on the top 341 of the drift region. The first electrode structure 38 and the second electrode structure 39 are located between the drift region 34 and the emitter 37. The first electrode structure 38 includes a first insulation layer 381 and a first electrode 382, and the first insulation layer 381 is located on a periphery of the first electrode 382. The second electrode structure 39 includes a second insulation layer 391 and a second electrode 392, and the second insulation layer 391 is located on a periphery of the second electrode 392.

A buffer structure 50 is disposed between the first electrode 382 and the second electrode 392. When the semiconductor device 30 is turned on, the buffer structure 50 is configured to increase accumulation of carriers in the drift region 34. It should be noted that, that the buffer structure 50 is configured to increase accumulation of carriers in the drift region 34 may be understood as: When the semiconductor device 30 is turned on, carriers stored in the drift region 34 may pass through the buffer structure 50, but do not all pass through the buffer structure 50 in a centralized manner. The buffer structure 50 buffers passing of carriers, that is, accumulation of carriers in the drift region 34 is increased. Alternatively, that the buffer structure 50 is configured to increase accumulation of carriers in the drift region 34 when the semiconductor device 30 is turned on may be understood as: when the semiconductor device 30 is turned on, carriers stored in the drift region 34 do not pass through the buffer structure 50, that is, the buffer structure 50 blocks carriers from passing between the first electrode 382 and the second electrode 392. This excludes one flow path of carriers, and reduces the flow of carriers stored in the drift region 34. That is, the buffer structure 50 increases accumulation of carriers stored in the drift region 34.

In this application, the buffer structure 50 is disposed between the first electrode 382 and the second electrode 392, to buffer the flow of carriers stored in the drift region 34 when the semiconductor device 30 is turned on, that is, accumulation of carriers in the drift region 34 is increased, thereby helping reduce turn-on voltage drop of the semiconductor device 30. Specifically, in a process of turning on the semiconductor device 30, holes and electrons accumulate in the drift region 34. Therefore, the drift region 34 stores holes and electrons. Holes stored in the drift region 34 need to continuously flow to the top 341 of the drift region 34, and further to pass through other function layers disposed in a stacked manner on the top 341 of the drift region 34, to form a current. However, after a large quantity of holes flow from the drift region 34 to other functional layers, holes stored in the drift region 34 decrease. This increases the turn-on voltage drop of the semiconductor device 30. The buffer structure 50 is disposed between the first electrode 382 and the second electrode 392, that is, the buffer structure 50 is disposed on the top 341 of the drift region 34. In this way, when the semiconductor device 30 is turned on, the buffer structure 50 may buffer the flow of holes stored in the drift region 34, to increase accumulation of carriers stored in the drift region 34, reduce the turn-on voltage drop of the semiconductor device 30, and optimize performance of the semiconductor device 30.

Refer to FIG. 3. FIG. 3 is an enlarged schematic diagram of a structure at H of the semiconductor structure 30 shown in FIG. 2. The first electrode 382 includes a first bottom 3821 and a first top 3822 that are disposed opposite to each other along the second direction A2, and a first side portion 3823 and a second side portion 3824 that are disposed opposite to each other in the first direction A1. The first insulation layer 381 surrounds the first side portion 3823, the first bottom 3821, and the second side portion 3824. The first bottom 3821 is disposed adjacent to the drift region 34. The first top 3822 of the first electrode 382 is electrically connected to the emitter 37. That the first top 3822 of the first electrode 382 is electrically connected to the emitter 37 may be understood as: The first top 3822 of the first electrode 382 is not insulated from the emitter 37. The first electrode 382 and the emitter 37 may have an equal potential. This helps reduce a Miller capacitance of the semiconductor device 30, improve a switching speed of the semiconductor device 30, and reduce switching loss of the semiconductor device 30.

The second electrode 392 may be a gate electrode. The second electrode 392 includes a second bottom 3921 and a second top 3922 that are disposed opposite to each other along the second direction A2, and a third side portion 3923 and a fourth side portion 3924 that are disposed opposite to each other along the first direction A1. The second insulation layer 391 surrounds the third side portion 3923, the second bottom 3921, and the fourth side portion 3924. The second bottom 3921 is disposed adjacent to the drift region 34. The second top 3922 of the second electrode 392 is insulated from the emitter 37. The insulation may be understood as insulation between the second top 3922 of the second electrode 392 and the emitter 37. Specifically, an insulation dielectric layer 36 may be disposed between the second top 3922 of the second electrode 392 and the emitter 37, to implement insulation between the second top 3922 of the second electrode 392 and the emitter 37. In addition, the second top 3922 of the second electrode 392 may alternatively be insulated from the emitter 37 in another manner.

With reference to FIG. 2 and FIG. 3, when the semiconductor device 30 is turned on, the collector region 32 can generate holes, and holes flow from the collector region 32 to the front side 310 of the semiconductor device 30, to generate a current. A direction of the current is the same as a flow direction of holes, and both directions are from the back side 320 of the semiconductor device 30 to the front side 310 of the semiconductor device 30. Specifically, the collector region 32 may be a P+ type semiconductor. In another implementation, the collector region 32 may alternatively be an N+ type semiconductor. In this case, the semiconductor device 30 mainly performs conduction of electrons, and does not generate holes. The collector region 32 in this embodiment is a P+ type semiconductor.

The field blocking layer 33 can prevent holes generated in the collector region 32 from flowing to the drift region. When the semiconductor device 30 is turned on, holes need to flow to the drift region 34. However, a large quantity of holes flow into the drift region 34 in a centralized manner, causing a relatively large generated current. A larger current indicates larger loss. Therefore, the field blocking layer 33 is disposed, so that holes can pass through the field blocking layer 33 and flow to the drift region 34. The field blocking layer 33 can further hinder and slow the flow of holes to the drift region 34, so as to control a current and reduce loss of the semiconductor device 30. That is, the field blocking layer 33 only hinders the flow of holes to the drift region 34, and does not completely prevent holes from flowing to the drift region 34, and still there are holes continuously injected into the drift region 34. In addition, a depletion region (not shown in the figure) extends from the front side 310 of the semiconductor device 30 to the back side 320, and the extension is limited by an impurity doping concentration. The depletion region can be extended only when the impurity doping concentration is relatively low, and cannot be extended when the impurity doping concentration is high. When the depletion region extends from the drift region 34 to the field blocking layer 33, because the impurity doping density of the field blocking layer 33 is higher than the impurity doping density of the drift region 34, the depletion region cannot further extend to the collector region 32, to avoid a short circuit caused by extension of the depletion region to the collector region 32. Specifically, the field blocking layer 33 may be an N-type semiconductor, so that the impurity doping concentration of the field blocking layer 33 is higher than the impurity doping concentration of the drift region 34.

There are two floating regions: a first floating region 351 and a second floating region 352. The first floating region 351 and the second floating region 352 are distributed on the top 341 of the drift region 34 at an interval. In the first direction A1, the first floating region 351, the first electrode 382, the buffer structure 50, and the second electrode 392 are arranged in sequence. The first floating region 351 is the same as the second floating region 352. The first floating region 352 is used as an example. The first floating region 351 is in a floating state, and holes gather below the first floating region 351. According to an electrical neutrality requirement, electrons also gather below the first floating region 351, that is, electrons and holes accumulate in the drift region 34, and the drift region 34 stores a large quantity of electrons and holes. This improves a concentration of electrons and holes in the drift region 34, and helps reduce turn-on voltage drop of the semiconductor device 30. Specifically, the first floating region 351 may be a P-type semiconductor. Similarly, the second floating region 352 is also a P-type semiconductor, and electrons and holes also accumulate below the second floating region 352.

The first floating region 351 and the second floating region 352 may assist in exhausting the drift region 34 and increasing a voltage of the semiconductor device 30 when the semiconductor device 30 withstands a voltage. In addition, the first floating region 351 and the second floating region 352 may be used as electron and hole blocking layers, so as to improve a concentration of carriers on a surface of the semiconductor device 30 when the semiconductor device 30 is turned on, and improve a concentration and distribution of carriers in the drift region 34, thereby reducing turn-on voltage drop of the semiconductor device 30.

The second electrode structure 39 is located between the first floating region 351 and the second floating region 352. There are two first electrode structures 38, and the two first electrode structures 38 are spaced apart. One first electrode structure 38 is disposed on an edge, facing the second floating region 352, of the first floating region 351, and one first electrode structure 38 is disposed on an edge, facing the first floating region 351, of the second floating region 352. One first electrode structure 38 isolates the first floating region 351 from the second electrode structure 39, and the other first electrode structure 38 isolates the second floating region 352 from the second electrode structure 39. In other words, the second electrode structure 39 is located between two first electrode structures 38, that is, one first electrode structure 38 is located between the first floating region 351 and the second electrode structure 39, and the other first electrode structure 38 is located between the second floating region 352 and the second electrode structure 39. This avoids an oscillation problem of the second electrode structure 39 caused by direct contact between the first floating region 351 and the second electrode structure 39 and direct contact between the second floating region 352 and the second electrode structure 39. The oscillation problem of the second electrode structure 39 means that, if there is no first electrode structure 38, when the first floating region 351 is in direct contact with the second electrode structure 39 or the second floating region 352 is in direct contact with the second electrode structure 39, and when the semiconductor device 30 is turned on, a potential change in the floating region 351 and the second floating region 352 is caused due to accumulation of holes at a lower part of the first floating region 351 and a lower part of the second floating region 352 and is fed back to the second electrode structure 39 through a gate capacitor. Consequently, oscillation of the second electrode structure 39 occurs when the semiconductor device 30 is turned on, deteriorating an electromagnetic interference feature of the semiconductor device 30, and affecting reliability of the semiconductor device 30.

A function of the insulation dielectric layer 36 is to implement insulation. The insulation dielectric layer 36 is disposed between the floating region 35 and the emitter 37, and the insulation dielectric layer 36 is disposed between the second electrode 392 and the emitter 37.

With reference to FIG. 2 and FIG. 3, in a specific embodiment, the first electrode structure 38 and the second electrode structure 39 are spaced apart, and the semiconductor device 30 forms a P-type channel 63. The P-type channel 63 includes the first electrode structure 38 and the first channel structure 58. The first channel structure 58 is formed between the first electrode structure 38 and the second electrode structure 39, and the first channel structure 58 is connected between the emitter 37 and the drift region 34. Specifically, the first channel structure 58 includes a buffer layer 51, a charge layer 52, and a contact layer 53 that are disposed in a stacked manner. The charge layer 52 may be a P-type semiconductor, and the drift region 34, the buffer layer 51, the charge layer 52, the contact layer 53, and the emitter 37 are stacked in sequence. The first channel structure 58 is used for flow of holes, that is, holes may flow through the first channel structure 58 between the first electrode structure 38 and the second electrode structure 39. In addition, the first channel structure 58, the first insulation layer 381, and the second insulation layer 391 jointly form the buffer structure 50. When the semiconductor device 30 is turned on, the buffer structure 50 may buffer the flow of carriers stored in the drift region 34, to increase accumulation of carriers in the drift region 34. When the semiconductor device 30 is turned off, holes may flow out of the drift region 34 through the first channel structure 58 between the first electrode structure 38 and the second electrode structure 39. This adds an extra path for extraction of holes, and helps improve a turn-off speed of the semiconductor device 30.

In other words, when the first electrode structure 38 and the second electrode structure 39 are spaced apart, after the semiconductor device 30 is turned on, carriers stored in the drift region 34 may pass through the buffer structure 50, but do not all pass through the buffer structure 50 in a centralized manner. The buffer structure 50 buffers the flow of carriers, to increase a concentration of carriers accumulated in the drift region 34, thereby helping reduce the turn-on voltage drop of the semiconductor device 30. When the semiconductor device 30 is turned off, carriers may pass through the buffer structure 50, to accelerate extraction of carriers stored in the drift region 34, thereby helping improve a turn-off speed of the semiconductor device 30, and reduce turn-off loss of the semiconductor device 30.

The buffer layer 51, the first insulation layer 381, and the second insulation layer 391 jointly form the buffer structure 50. The buffer layer 51 is located between the drift region 34 and the charge layer 52, and the buffer layer 51 is located between the first electrode structure 38 and the second electrode structure 39. The buffer layer 51 is in contact with the first insulation layer 381, and the buffer layer is in contact with the second insulation layer 391. If the buffer layer 51 is disposed below the first electrode structure 38 and the second electrode structure 39, an electric field at a lower part of the buffer layer 51 is greater than an electric field at the bottom of the first electrode structure 38 and an electric field at the bottom of the second electrode structure 39. An electric field is mainly concentrated at the lower part of the buffer layer 51, and the buffer layer 51 is prone to a breakdown. In this embodiment, the buffer layer 51 is disposed between the first electrode structure 38 and the second electrode structure 39, the electric field at the bottom of the first electrode structure 38 and the electric field at the bottom of the second electrode structure 39 are greater than the electric field at the lower part of the buffer layer 51, and the electric field is mainly concentrated at the bottom of the first electrode structure 38 and the bottom of the second electrode structure 39. In this way, the buffer layer 51 is not prone to a breakdown.

When the semiconductor device 30 is turned on, the buffer structure 50 may be configured to buffer the flow of holes stored in the drift region 34. Holes are generated by a P-type semiconductor, and the flow of holes in an N-type semiconductor is hindered. Therefore, to buffer the flow of holes, the buffer layer 51 is set as an N-type semiconductor. In this way, the flow of holes can be effectively buffered, to reduce turn-on voltage drop of the semiconductor device 30 and optimize performance of the semiconductor device 30.

It should be noted that an impurity doping concentration of the buffer layer 51 is adjustable. Changing the impurity doping concentration of the buffer layer 51 can change a threshold voltage of the first channel structure 58 between the first electrode structure 38 and the second electrode structure 39. The change of the threshold voltage may adjust an extraction speed of holes, to improve a compromise between the turn-on voltage drop and the turn-off loss of the semiconductor device 30.

The contact layer 53 is located between the charge layer 52 and the emitter 37. The contact layer 53 is in direct contact with the emitter 37. The contact layer 53 may be a P+ type semiconductor, that is, an impurity doping concentration of the contact layer 53 is greater than an impurity doping concentration of the charge layer 52. A contact resistance is related to the impurity doping concentration. A larger impurity doping concentration indicates a smaller contact resistance. A contact resistance of direct contact between the charge layer 52 and the emitter 37 is relatively large. The impurity doping concentration of the contact layer 53 is set to be greater than the impurity doping concentration of the charge layer 52, so that the contact resistance can be reduced when the contact layer 53 is in contact with the emitter 37, thereby reducing switching loss and function loss of the semiconductor device 30.

In a specific implementation, the buffer structure 50 may be in contact with the drift region 34, and the contact between the buffer structure 50 and the drift region 34 can effectively buffer the flow of carriers stored in the drift region 34, thereby reducing the turn-on voltage drop of the semiconductor device 30. In another implementation, the buffer structure 50 may not be in contact with the drift region 34, that is, another structure may be disposed between the buffer structure 50 and the drift region 34.

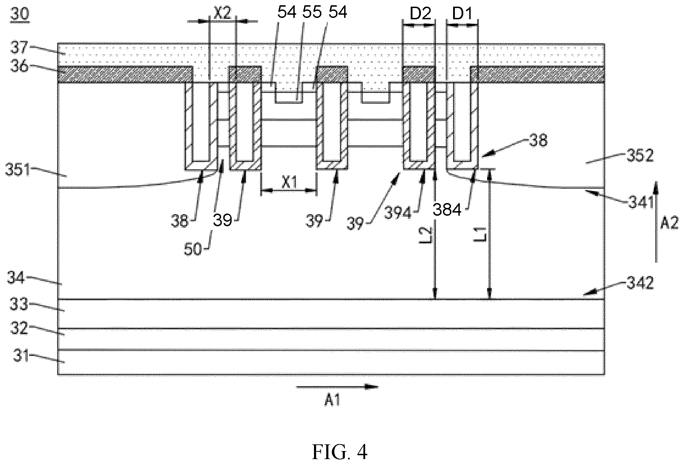

It may be understood that, in this embodiment, there may be two second electrode structures 39 (refer to FIG. 2), or there may be three second electrode structures 39 (refer to FIG. 4). In another implementation, the quantity of the second electrode structures 39 may be one, four, five, six, or the like. This is not limited in this application. When there are a plurality of second electrode structures 39, the buffer structure 50 is located between the first electrode structure 38 and the second electrode structures 39 that are adjacent to each other.

With reference to FIG. 2, two second electrode structures 39 are used as an example. The semiconductor device 30 is provided with an N-type channel 64, and the N-type channel 64 includes a second electrode structure 39 and a second channel structure 59. The second channel structure 59 includes a first emission region 54, a second emission region 55, a base region 56, and a storage region 57. The first emission region 54 can generate electrons, and electrons flow from the first emission region 54 to a back side 320 of the semiconductor device 30. Specifically, the first emission region 54 may be an N+ type semiconductor. The base region 56 may be a P-type semiconductor, and the storage region 57 may be an N-type semiconductor. A second emission region 55 is further disposed between the two adjacent second electrode structures 39, and the second emission region 55 may be a P+ type semiconductor. Because an impurity doping concentration of the second emission region 55 is relatively high, when the second emission region 55 is in contact with the emitter 37, a contact resistance can be reduced, thereby reducing switching loss, function loss, and the like of the semiconductor device 30. In addition, a part of the emitter 37 in this embodiment extends between two first emission regions 54, to effectively suppress a latch of the semiconductor device 30.

It may be understood that, after the N-type channel 64 is turned on, electrons generated in the first emission region 54 may flow to the drift region 34 through the second channel structure 59, and further to flow to the back side 320 of the semiconductor device 30. Holes generated in the collector region 32 may also flow to the front side 310 of the semiconductor device 30 through the second channel structure 59.

With reference to FIG. 4, in this embodiment, sizes X2 of the buffer structure 50 in the first direction A1 are less than a spacing X1 between two adjacent second electrode structures 39. This helps reduce a gate capacitance, improve a switching speed, reduce turn-off loss, and optimize performance of the semiconductor device.

With reference to FIG. 2 and FIG. 3, in a specific embodiment, the first electrode structure 38 and the second floating region 352 are used as an example. The first electrode structure 38 includes a first top surface 383 and a first bottom surface 384 that are disposed opposite to each other, the first top surface 383 is disposed away from the drift region 34, the first top surface 383 may be flush with a surface that is of the second floating region 352 and that is away from the drift region 34, or there may be a height difference, and the second floating region 352 covers the first bottom surface 384. That is, a part of the second floating region 352 is disposed between the first bottom surface 384 of the first electrode structure 38 and the drift region 34, and the first bottom surface 384 is in contact with the second floating region 352. The second floating region 352 covers the first bottom surface 384 of the first electrode structure 38, to alleviate electric field concentration at a lower part of the first electrode structure 38, thereby avoiding a breakdown at the lower part of the first electrode structure 38, and improving reliability of the semiconductor device 30.

In addition, in this application, a size X2 of the buffer structure 50 in the first direction A1 may be set to be less than the spacing X1 between two adjacent second electrode structures 39. In other words, the spacing between the first electrode structure 38 and the second electrode structure 39 that are adjacent to each other may be very small, and the second electrode structure 39 is disposed adjacent to the first electrode structure 38. In this way, the second floating region 352 covers the first bottom surface 384 of the first electrode structure 38 to alleviate electric field concentration at the lower part of the first electrode structure 38, and meanwhile alleviate electric field concentration at a lower part of the second electrode structure 39 adj acent to the first electrode structure 38, thereby avoiding a breakdown at the lower part of the second electrode structure 39, and improving reliability of the semiconductor device 30. Similarly, the first floating region 351 covers the first bottom surface 384 of the first electrode structure 38. For details, refer to the descriptions of the second floating region 352 and the first electrode structure 38. Details are not described herein again.

The second electrode structure 39 includes a second top surface 393 and a second bottom surface 394 that are disposed opposite to each other, and the second top surface 393 is disposed away from the drift region 34. Both the first bottom surface 384 of the first electrode structure 38 and the second bottom surface 394 of the second electrode structure 39 are connected to the top 341 of the drift region 34. It may be understood that the first bottom surface 384 and the second bottom surface 394 may be in direct contact with or in indirect contact with the top 341 of the drift region 34. For example, a part of the first floating region 351 or a part of the second floating region 352 is disposed between the first bottom surface 384 and the drift region 34, that is, the first floating region 351 or the second floating region 352 covers the first bottom surface 384 of the first electrode structure 38.

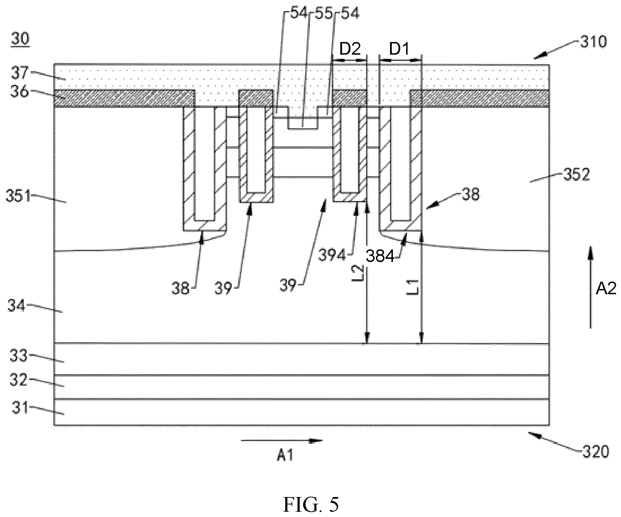

With reference to FIG. 4, a spacing L1 between the first bottom surface 384 and the bottom 342 may be the same as a spacing L2 between the second bottom surface 394 and the bottom 342. In another implementation, with reference to FIG. 5, a spacing L1 between the first bottom surface 384 and the bottom 342 may alternatively be set to be less than a spacing L2 between the second bottom surface 394 and the bottom 342. Electric field strength gradually increases from the front side 310 of the semiconductor device 30 to the back side 320 of the semiconductor device 30, that is, electric field strength gradually increases from the top 341 of the drift region 34 to the bottom 342 of the drift region 34. The spacing L1 between the first bottom surface 384 and the bottom 342 is limited to being less than the spacing L2 between the second bottom surface 394 and the bottom 342, so that the electric field strength at the lower part of the first electrode structure 38 is greater than the electric field strength at the lower part of the second electrode structure 39. In this way, an electric field is mainly concentrated at the lower part of the first electrode structure 38, to avoid damage to the second electrode structure 39. If the spacing L1 between the first bottom surface 384 and the bottom 342 is the same as the spacing L2 between the second bottom surface 394 and the bottom 342, the electric field strength at the lower part of the first electrode structure 38 is the same as the electric field strength at the lower part of the second electrode structure 39. In this way, if a breakdown occurs, both the first electrode structure 38 and the second electrode structure 39 are damaged, increasing a degree of damage to the semiconductor device 30.

With reference to FIG. 4, a size D1 of the first electrode structure 38 in the first direction A1 may be equal to a size D2 of the second electrode structure 39 in the first direction A1. In another implementation, with reference to FIG. 5, a size D1 of the first electrode structure 38 in the first direction A1 may be greater than a size D2 of the second electrode structure 39 in the first direction A1. In this way, electric field concentration at the bottom of the first electrode structure 38 can be alleviated, and stability of the semiconductor device 30 can be improved.

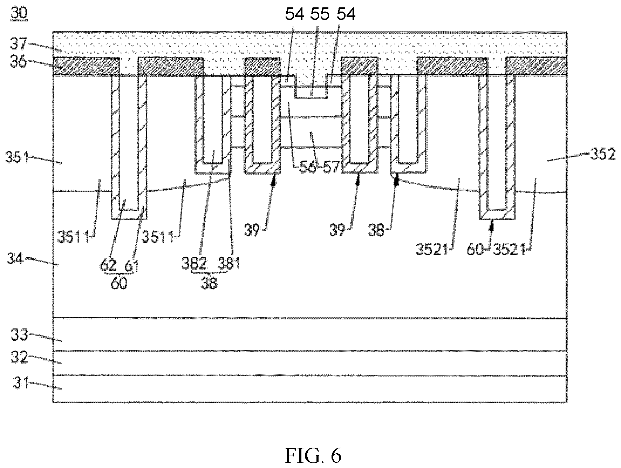

As shown in FIG. 6, the first floating region 351 includes at least two first floating portions 3511, and the at least two first floating portions 3511 are spaced apart. A third electrode structure 60 is disposed between adjacent first floating portions 3511. The third electrode structure 60 includes a third insulation layer 61 and a third electrode 62, and the third insulation layer 61 is located on a periphery of the third electrode 62. Performance, a material, a structure, and the like of the third insulation layer 61 are the same as those of the first insulation layer 381, and performance, a material, a structure, and the like of the third electrode 62 are the same as those of the first electrode 382. That is, the third electrode structure 60 and the first electrode structure 38 have the same performance, material, structure, and the like, but are located at different positions. Specifically, the first electrode structure 38 is located on an edge of the first floating region 351, and the third electrode structure 60 is located between two first adjacent floating portions 3511. Therefore, this may be understood as: In this application, a plurality of first electrode structures 38 may be disposed, but for differentiation purposes, an electrode structure located between two adjacent first floating portions 3511 is referred to as the third electrode structure 60. The third electrode structure 60 and the emitter 37 have an equal potential. This helps reduce a Miller capacitance of the semiconductor device 30, improve a switching speed of the semiconductor device 30, and reduce switching loss of the semiconductor device 30. In this embodiment, the third electrode structure 60 is disposed, to reduce a gate capacitance, and improve a switching speed.

The quantity of third electrode structures 60 may be one, two, three, four, five, six, or the like. This is not limited in this application. A lower part of the third electrode structure 60 may not be covered by the first floating portion 3511, or a lower part of the third electrode structure 60 may be covered by the first floating portion 3511. When the first floating portion 3511 covers the lower part of the third electrode structure 60, damage to the second electrode structure 39 can be avoided.

A spacing between the third electrode structure 60 and the first electrode structure 38 that are adjacent to each other may be greater than, less than, or equal to a spacing between two adjacent second electrode structures 39. When the spacing between the third electrode structure 60 and the first electrode structure 38 that are adjacent to each other is less than the spacing between two adjacent second electrode structures 39, it helps reduce a gate capacitance, improve a switching speed, reduce turn-off loss, and optimize performance of the semiconductor device 30.

Similarly, the second floating region 352 may also include at least two second floating portions 3521, and the at least two second floating portions 3521 are spaced apart. A third electrode structure 60 is disposed between adjacent second floating portions 3521. For specific arrangement of the third electrode structure 60 in the second floating region 352, refer to the arrangement of the third electrode structure 60 in the first floating region 351. Details are not described herein again.

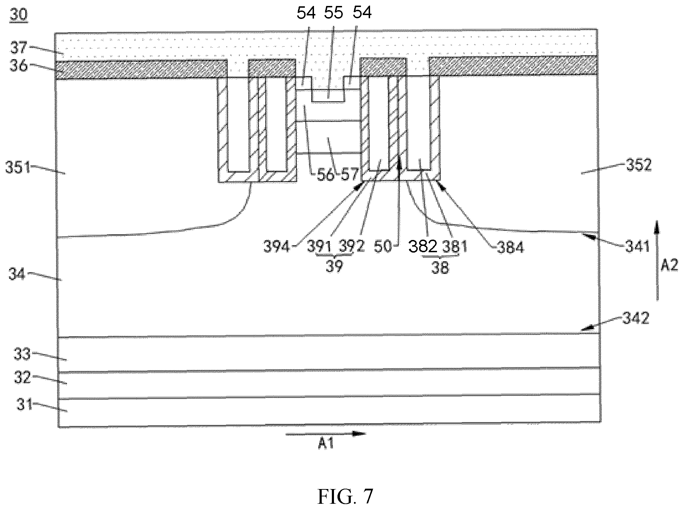

As shown in FIG. 7, FIG. 7 is a schematic diagram of a structure of a semiconductor device. The first electrode structure 38 is in contact with the second electrode structure 39, and a part of the first insulation layer 381 and a part of the second insulation layer 391 are interconnected together between the first electrode 382 and the second electrode 392 to form the buffer structure 50. With reference to FIG. 3 and FIG. 7, the part of the first insulation layer 381 means a part that is of the first insulation layer 381 and that is in contact with the second side portion 3824, and the part of the second insulation layer 391 means a part that is of the second insulation layer 391 and that is in contact with the fourth side portion 3924. In this implementation, the first insulation layer 381 is in contact with the second insulation layer 391, and the buffer structure 50 blocks carriers from passing between the first electrode 382 and the second electrode 392, that is, holes stored in the drift region 34 do not pass between the first electrode 382 and the second electrode 392. This excludes one flow path of holes (in this case, holes can pass only between two adj acent second electrode structures 39, and cannot pass between the first electrode structure 38 and the second electrode structure 39 that are adjacent to each other), and alleviates the flow of holes stored in the drift region 34. That is, the buffer structure 50 buffers the flow of holes stored in the drift region 34. This helps increase accumulation of carriers stored in the drift region 34, and reduce the turn-on voltage drop of the semiconductor device 30. The first insulation layer 381 is in contact with the second insulation layer 391, so that a spacing between the first electrode structure 38 and the second electrode structure 39 is zero. This helps reduce a gate capacitance, improve a switching speed of the semiconductor device 30, and meanwhile reduce electric field concentration at the bottom of the second electrode structure 39, thereby improving reliability of the semiconductor device.

With reference to FIG. 7, when the first insulation layer 381 is in contact with the second insulation layer 391 and the first bottom surface 384 of the first electrode structure 38 is coplanar with the second bottom surface 394 of the second electrode structure 39, the first floating region 351 partially covers the first bottom surface 384 of the first electrode structure 38, and the second floating portion 352 partially covers the first bottom surface 384 of the first electrode structure 38. That is, the first floating portion 351 is not in contact with the second electrode structure 39, and the second floating portion 352 is not in contact with the second electrode structure 39, to avoid an oscillation problem of the second electrode structure 39 caused by contact between the first floating region 351 and the second electrode structure 39 and contact between the second floating region 352 and the second electrode structure 39.

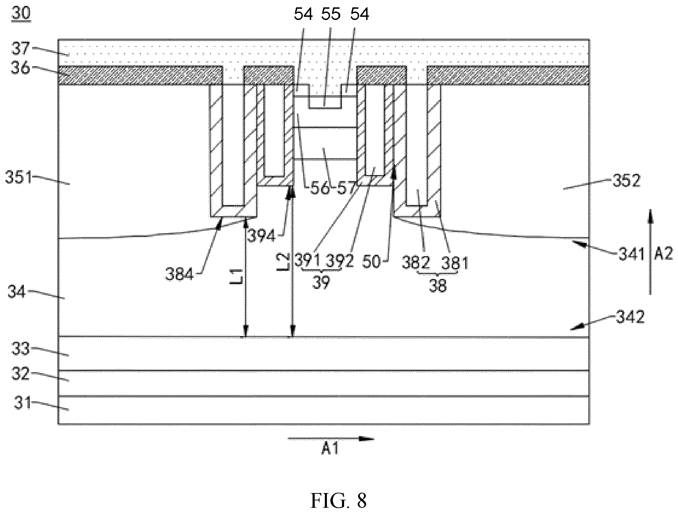

With reference to FIG. 8, when the first insulation layer 381 is in contact with the second insulation layer 391, a spacing L1 between the first bottom surface 384 and the bottom 342 is less than a spacing L2 between the second bottom surface 394 and the bottom 342, so that electric field strength in a lower part of the first electrode structure 38 is greater than electric field strength in a lower part of the second electrode structure 39. In this way, an electric field is mainly concentrated at the lower part of the first electrode structure 38, to alleviate electric field concentration at the lower part of the second electrode structure 39, thereby avoiding damage to the second electrode structure 39, and helping improve stability of the semiconductor device 30.

When the first insulation layer 381 is in contact with the second insulation layer 391, that is, a spacing between the first electrode structure 38 and the second electrode structure 39 is zero, the second floating region 352 covers the first bottom surface 384 of the first electrode structure 38, to alleviate electric field concentration at the lower part of the first electrode structure 38, thereby avoiding a breakdown at the lower part of the first electrode structure 38, and improving reliability of the semiconductor device 30. In addition, the spacing between the first electrode structure 38 and the second electrode structure 39 is zero, and the second electrode structure 39 is in contact with the first electrode structure 38. In this way, the second floating region 352 covers the first bottom surface 384 of the first electrode structure 38, to alleviate electric field concentration in the lower part of the first electrode structure 38, and meanwhile alleviate electric field concentration in the lower part of the second electrode structure 39 in contact with the first electrode structure 38, thereby avoiding a breakdown at the lower part of the second electrode structure 39, and improving reliability of the semiconductor device 30.

When the first insulation layer 381 is in contact with the second insulation layer 391, the quantity of the second electrode structures 39 may be two, three, four, five, six, or the like. The first floating region 351 may also include at least two first floating portions, and a third electrode structure is disposed between two adjacent first floating portions. The second floating region 352 may also include at least two second floating portions, and a third electrode structure is disposed between two adjacent second floating portions. For details, refer to a case in which the first electrode structure 38 and the second electrode structure 39 are spaced apart. Details are not described herein again.

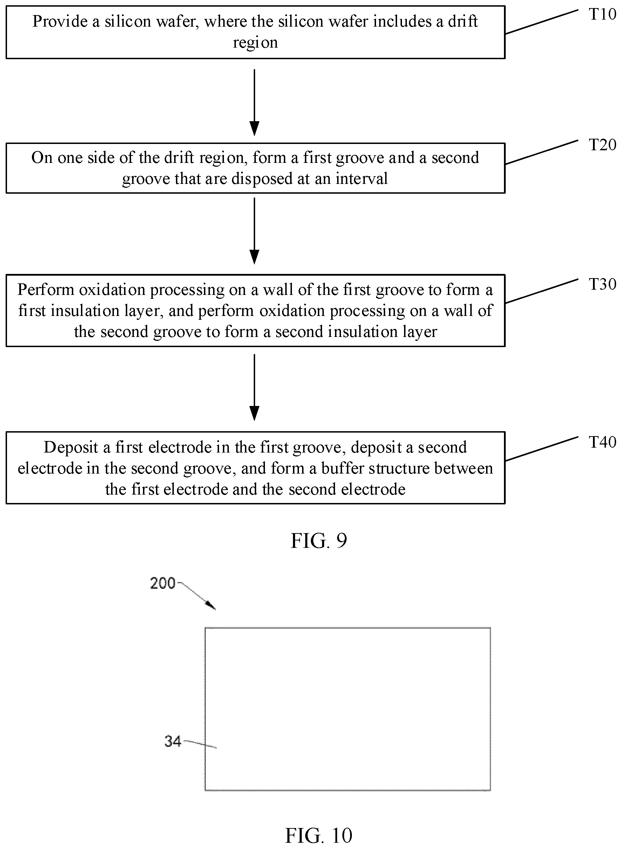

Second, this application provides method for preparing a semiconductor device 30. As shown in FIG. 9, the method for preparing a semiconductor device 30 in an implementation specifically includes the following steps.

T10: Provide a silicon wafer 200, where the silicon wafer 200 includes a drift region 34.

With reference to FIG. 10, the drift region 34 may be an N-type semiconductor. In another implementation, the drift region may alternatively be a P-type semiconductor. In this embodiment, that the drift region 34 is an N-type semiconductor is used as an example. A silicon wafer with a thickness of 500 µm to 750 µm is provided. An impurity doping concentration of the drift region 34 may be 10¹³ cm ⁻³ to 10¹⁴ cm ⁻³, and an impurity doped in the drift region 34 may be phosphorus, arsenic, or the like. It should be noted that, in this embodiment, the thickness of the drift region 34, the impurity doping concentration, and the like are merely representations as examples, and are not limited in this application.

T20: On one side of the drift region 34, form a first groove 354 and a second groove 355 that are spaced apart.

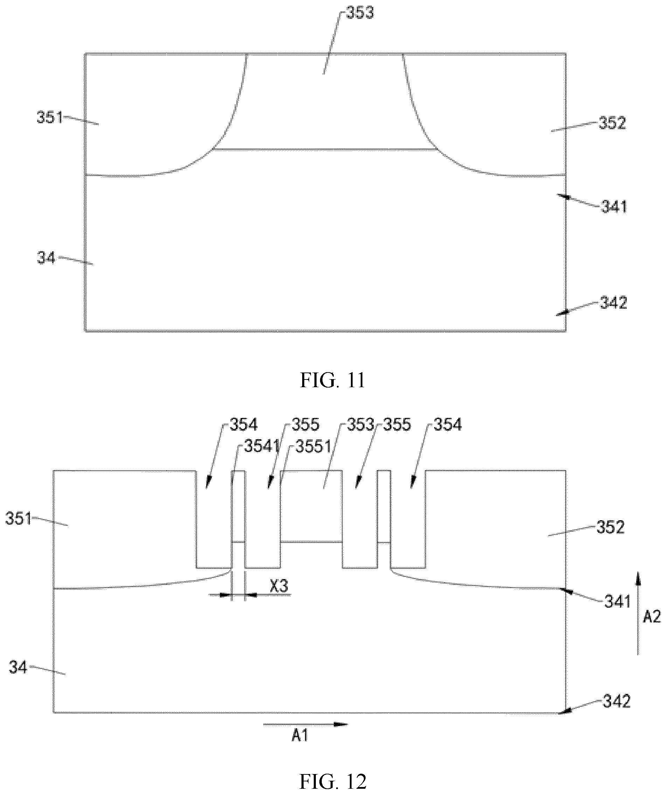

Refer to FIG. 11. FIG. 11 is a schematic diagram of a structure of forming a first floating region 351, a second floating region 352, and a channel region 353. A layer of field oxygen (not shown in FIG. 11) is grown on a surface of the silicon wafer 200, an active region (not shown in FIG. 11) is obtained through photoetching, and then a layer of oxide (usually silicon dioxide) is grown, to prevent damage to the surface of the silicon wafer caused by directly performing ion injection processing without the oxide layer. Then, a P-type impurity (the P-type impurity may be boron, aluminum, indium, or the like) is injected into an upper side of the drift region 34 through ion injection, and annealing processing is performed to form the first floating region 351 and the second floating region 352. The first floating region 351 and the second floating region 352 are spaced apart and are located on two sides above the drift region 34. Ion injection energy of the first floating region 351 and the second floating region 352 is 300 keV to 10000 keV, an injection dose is 1*10¹¹ cm⁻² to 8*10¹² cm⁻², an annealing temperature is 900°C to 1150°C, and an annealing time is 20 minutes to 60 minutes.

It should be noted that this embodiment merely provides a process condition that can be implemented, such as ion injection energy, an injection dose, an annealing temperature, and an annealing time of the first floating region 351 and the second floating region 352. This is not limited in this application. In an actual operation process, the ion injection energy, the injection dose, the annealing temperature, the annealing time, and the like of the first floating region 351 and the second floating region 352 may be changed as required. Similarly, this application does not limit a process condition formed by another structure, but merely provides an implementable manner, and details are not described subsequently again.

An N-type impurity (the N-type impurity may be phosphorus, arsenic, or the like) is injected into a region between the first floating region 351 and the second floating region 352 through ion injection, and annealing processing is performed, to form the channel region 353. That is, the first floating region 351 is located on the left side of the channel region 353, and the second floating region 352 is located on the right side of the channel region 353. Ion injection energy of the channel region 353 is 1000 KeV to 2000 KeV, an injection dose is 1*10¹³ cm⁻² to 1*10¹⁴ cm⁻², an annealing temperature is 900°C to 1150°C, and an annealing time is 40 minutes to 100 minutes.

Refer to FIG. 12. FIG. 12 is a schematic diagram of a structure of a first groove 354 and a second groove 355. On one side that is of the first floating region 351, the second floating region 352, and the channel region 353 and that is away from the drift region 34, plasma-enhanced chemical vapor deposition is performed, and an oxide film of 4000 A to 8000 A is formed through backflow. Surfaces of the first floating region 351, the second floating region 352, and the channel region 353 are exposed and etched to form the first groove 354 and the second groove 355.

T30: Perform oxidation processing on a wall 3541 of the first groove 354 to form a first insulation layer 381, and perform oxidation processing on a wall 3551 of the second groove 355 to form a second insulation layer 391.

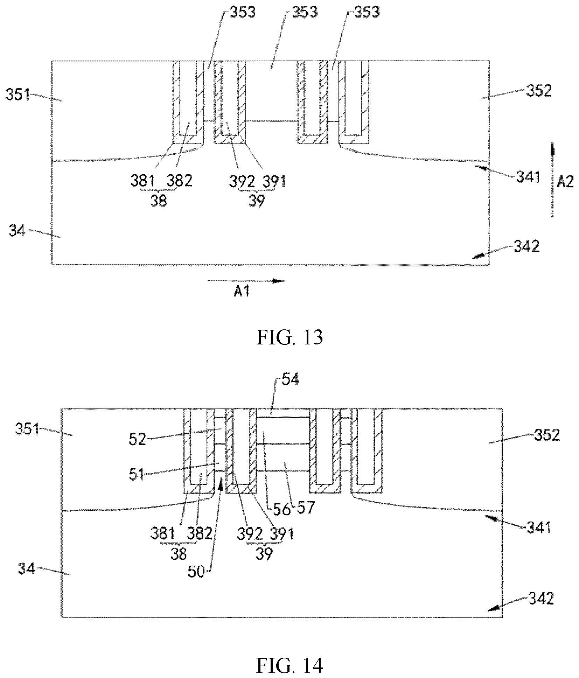

With reference to FIG. 12 and FIG. 13, sacrificial oxidation is performed on the wall 3541 of the first groove 354 and the wall 3551 of the second groove 355 at 1050°C to 1150°C, and after a sacrificial oxidation layer is removed by using hydrofluoric acid, the first insulation layer 381 and the second insulation layer 391 are grown at 1050°C to 1150°C in a dry oxygen atmosphere.

T40: Deposit a first electrode 382 in the first groove 354, and deposit a second electrode 392 in the second groove 355, and form a buffer structure 50 between the first electrode 382 and the second electrode 392.

With reference to FIG. 12 and FIG. 13, at 500°C to 950°C, the first electrode 382 is deposited in first groove 354, the first insulation layer 381 is located on a periphery of the first electrode 382, the second electrode 392 is deposited in the second groove 355, and the second insulation layer 391 is located on a periphery of second electrode 392. The first insulation layer 381 and the first electrode 382 jointly form the first electrode structure 38, and the second insulation layer 391 and the second electrode 392 jointly form the second electrode structure 39.

In a specific implementation, in a process of preparing the first insulation layer 381 and the second insulation layer 391, the first insulation layer 381 and the second insulation layer 391 are spaced apart. In other words, the first insulation layer 381 is not in contact with the second insulation layer 391. In this way, a first channel structure 58 (refer to FIG. 2) may be disposed between the first electrode structure 38 and the second electrode structure 39, to add a path for extraction of holes during turn-off, improve a turn-off speed of a semiconductor device 30, reduce turn-off loss of the semiconductor device 30, and improve a short-circuit feature of the semiconductor device 30. When the first insulation layer 381 and the second insulation layer 391 are spaced apart, the buffer structure 50 includes the first insulation layer 381, a buffer layer 51, and the second insulation layer 391, and the buffer structure 50 is configured to buffer the flow of carriers stored in the drift region 34. In this embodiment, an example in which the first insulation layer 381 and the second insulation layer 391 are spaced apart is used for detailed description.

With reference to FIG. 13 and FIG. 14, a layer of field oxygen is grown on a side that is of the first floating region 351 and that is away from the drift region 34, and an active region is obtained through photoetching. A P-type impurity is injected into an upper side of the channel region 353 through ion injection to form a charge layer 52 and a base region 56. A part between the first electrode structure 38 and the second electrode structure 39 is referred to as the charge layer 52, and a part between two adjacent second electrode structures 39 is referred to as the base region 56. The charge layer 52 and the base region 56 have a same doping concentration and junction depth. Ion injection energy is 30 KeV to 100 KeV, an injection dose is 1*10¹³ cm ⁻² to 1*10¹⁴ cm ⁻², an annealing temperature is 1050°C to 1150°C, and an annealing time is 20 minutes to 50 minutes.

It should be noted that no ion injection processing is performed on a lower side of the channel region 353, and the lower side, on which no ion injection is performed, of the channel region 353 is referred to as the buffer layer 51 and a storage region 57. A part between the first electrode structure 38 and the second electrode structure 39 is referred to as the buffer layer 51, and a part between two adjacent second electrode structures 39 is referred to as the storage region 57. The buffer layer 51 and the storage region 57 have a same doping concentration and junction depth. In other words, the buffer layer 51 is a part of the channel region 353, that is, when an N-type impurity is injected into the drift region 34 between the first floating region 351 and the second floating region 352 through ion injection and annealing processing is performed to form the channel region 353, the buffer layer 51 is also formed. The buffer layer 51 is formed before the first groove 354 and the second groove 355 are etched. The buffer layer 51 is located between the first insulation layer 381 and the second insulation layer 391, and the buffer layer 51, the first insulation layer 381, and the second insulation layer 391 jointly form the buffer structure 50. When the semiconductor device 30 is turned on, the buffer structure 50 is configured to increase accumulation of carriers in the drift region 34.

With reference to FIG. 14, an N-type impurity is injected into an upper side of the base region 56 through ion injection to form a first emission region 54, injection energy is 100 KeV to 200 KeV, and an injection dose is 1*10¹⁴ cm ⁻² to 9*10¹⁵ cm ⁻².

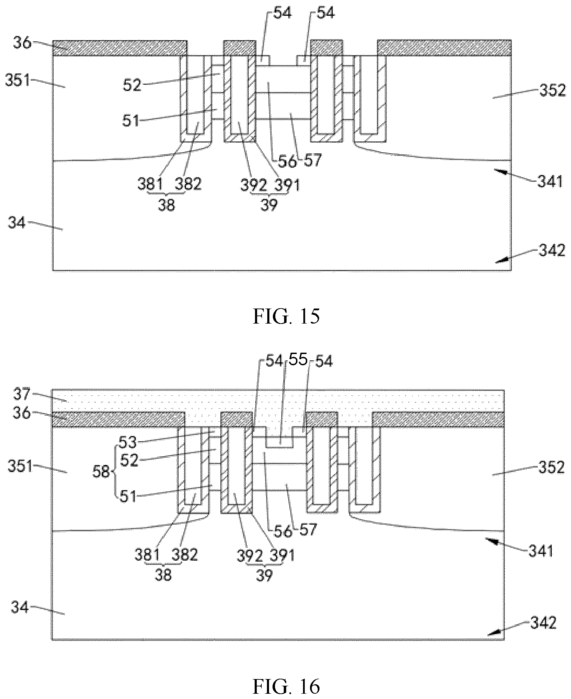

With reference to FIG. 15, an insulation dielectric layer 36 is deposited on a side on which the top 341 of the drift region 34 is located, and contact hole etching is performed on the insulation dielectric layer 36 and the first emission region 54, where the first emission region 54 is etched to form two first emission regions 54 spaced apart. Specifically, an etching depth may be 0.2 µm to 0.4 µm.

With reference to FIG. 16, pre-oxidation is first performed, then a P-type impurity is injected into a part of the base region 56 through ion injection to form a second emission region 55, and a P-type impurity is injected between the first insulation layer 381 and the second insulation layer 391 through ion injection to form the contact layer 53. The charge layer 52 is located between the buffer layer 51 and the contact layer 53. Ion injection energy of the contact layer 53 is 30 KeV to 100 KeV, and an ion injection dose is 1*10¹⁴ cm ⁻² to 9*10¹⁵ cm ⁻². The emitter 37 is then deposited on a side on which the top 341 of the drift region 34 is located.

A P-type impurity doping concentration of the contact layer 53 is greater than a P-type impurity doping concentration of the charge layer 52. In this way, a contact resistance can be reduced when the contact layer 53 is in contact with the emitter 37. This helps reduce switching loss, function loss, and the like of the semiconductor device 30.

With reference to the FIG. 2, the semiconductor device 30 is flipped, and an N-type impurity is implanted, through ion injection, into a side on which the bottom 342 of the drift region 34 is located, to form a field blocking layer 33. Ion injection energy is 300 KeV to 1000 KeV, and an ion injection dose 1*10¹² to 1 *10¹³ cm ⁻². A P-type impurity is implanted through ion injection to form a collector region 32. Ion injection energy is 10 KeV to 100 KeV, and an ion injection dose is 1*10¹² cm ⁻² to 1*10¹³ cm ⁻². Finally, a collector 31 is formed through deposition processing.

In a specific implementation, a size of the first groove 354 and the second groove 355 in a second direction A2 may be 4 µm to 7 µm. When the size of the first groove 354 and the second groove 355 in the second direction A2 is less than 4 µm, a preparation process is difficult, and it is difficult to form the first channel structure 58 between the first groove 354 and the second groove 355. When the size of the first groove 354 and the second groove 355 in the second direction A2 are greater than 7 µm, a capacitance increases, and electric field strength is large. Consequently, the first groove 354 and the second groove 355 are prone to a breakdown.

In a specific implementation, the size of the first groove 354 and the second groove 355 in a first direction A1 may be 0.6 µm to 1.8 µm. When the size of the first groove 354 and the second groove 355 in the first direction A1 is less than 0.6 µm, a preparation process is difficult. When the size of the first groove 354 and the second groove 355 in the first direction A1 is greater than 1.8 µm, a capacitance becomes larger.

It should be noted that in another implementation, exposure and etching may be performed to form the first groove 354 and the second groove 355 after the first floating region 351 and the second floating region 352 are formed, and then an N-type impurity (the N-type impurity may be phosphorus, arsenic, or the like) is injected into a region between the first floating region 351 and the second floating region 352 through ion injection, and annealing processing is performed to form the channel region 353 (that is, to form the buffer layer 51).

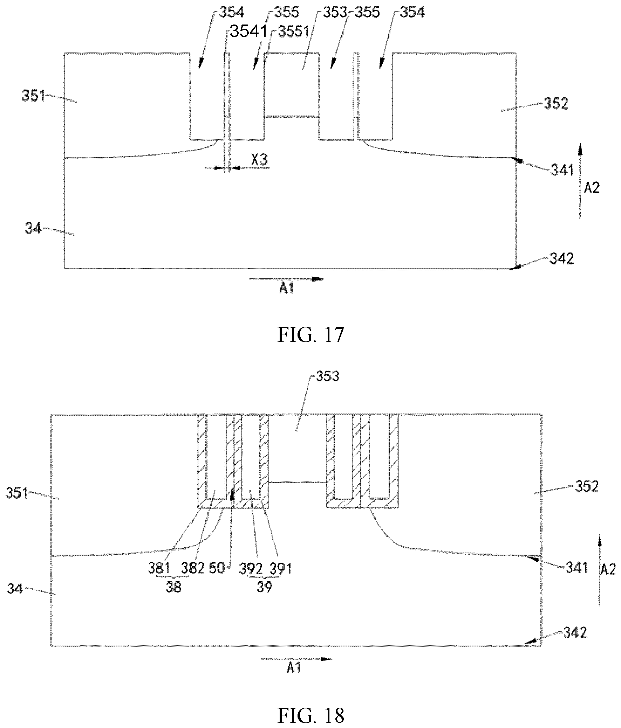

With reference to FIG. 17 and FIG. 18, in a specific implementation, in a process of preparing the first insulation layer 381 and the second insulation layer 391, the first insulation layer 381 and the second insulation layer 391 are interconnected together to form the buffer structure 50, that is, the first insulation layer 381 is in contact with the second insulation layer 391. A process of preparing the contact between the first insulation layer 381 and the second insulation layer 391 may be implemented in the following manner: A spacing X3 between the first groove 354 and the second groove 355 during etching may be 0.1 µm to 0.3 µm. When oxidation processing is performed on the wall 3541 of the first groove 354, a side that is along the first direction A1 and that faces the second groove 355 is oxidized to form the first insulation layer 381. When oxidation processing is performed on the wall 3551 of the second groove 355, a side that is along the first direction A1 and that faces the first groove 354 is oxidized to form the second insulation layer 391. In this way, when the spacing X3 between the first groove 354 and the second groove 355 is small (X3 is 0.1 µm to 0.3 µm), the formed first insulation layer 381 and second insulation layer 391 may be in contact with each other by controlling an oxidation process. When the spacing X3 between the first groove 354 and the second groove 355 is less than 0.1 µm, a process of preparing the first groove 354 and the second groove 355 is difficult. When the spacing X3 between the first groove 354 and the second groove 355 is greater than 0.3 µm, the spacing X3 between the first groove 354 and the second groove 355 is too large. Consequently, it is difficult for the first insulation layer 381 and the second insulation layer 391 formed during oxidation to be in contact with each other. It may be understood that the spacing X3 between the first groove 354 and the second groove 355 shown in FIG. 17 is less than the spacing X3 between the first groove 354 and the second groove 355 shown in FIG. 12, so that the first insulation layer 381 and the second insulation layer 391 formed in this embodiment are in contact with each other.

In this application, the first insulation layer 381 and the second insulation layer 391 are formed in different grooves (the first groove 354 and the second groove 355), and the first electrode 382 and the second electrode 392 are also located in different grooves. Compared with preparation of the first electrode 382 and the second electrode 392 in one groove (a process of preparing the first electrode 382 and the second electrode 392 in one groove is difficult, and a defect is likely to occur during groove preparation), in this embodiment of this application, the first electrode 382 is located in the first groove 354, and the second electrode 392 is located in the second groove 355. In other words, preparing the first electrode structure 38 and the second electrode structure 39 different grooves can reduce process and preparation difficulty, and reduce possibility of generation of a defect in groove preparation. When the first insulation layer 381 is in contact with the second insulation layer 391, the buffer structure 50 includes a part of the first insulation layer 381 and a part of the second insulation layer 391, and the buffer structure 50 is configured to buffer the flow of carriers stored in the drift region 34.

It should be noted that materials of the collector region 32, the field blocking layer 33, the drift region 34, the first floating region 351, the second floating region 352, the buffer layer 51, the charge layer 52, the contact layer 53, the first emission region 54, the second emission region 55, the base region 56, the storage region 57, the first electrode 382, and the second electrode 392 in this application may be Si, SiC, GaAs, GaN, or the like. In addition, parts of the collector region 32, the field blocking layer 33, the drift region 34, the first floating region 351, the second floating region 352, the buffer layer 51, the charge layer 52, the contact layer 53, the first emission region 54, the second emission region 55, the base region 56, the storage region 57, the first electrode 382, and the second electrode 392 may use a same material or different materials.

In this application, the buffer structure 50 is formed between the first electrode 382 and the second electrode 392. When the semiconductor device is turned on, the buffer structure 50 can effectively buffer the flow of carriers stored in the drift region 34. This improves a concentration of carriers in the drift region 34, increases accumulation of carriers in the drift region 34, and helps reduce turn-on voltage drop of the semiconductor device 30 and optimize performance of the semiconductor device 30. In this application, a second channel structure 59 can be formed between two adjacent second electrode structures 39, and when the first electrode structure 38 and the second electrode structure 39 are spaced apart, a first channel structure 58 may be further formed in this application. The first channel structure 58 provides an additional path for extraction of holes when the semiconductor device 30 is turned off. This accelerates extraction of carriers, and helps improve a turn-off speed of the semiconductor device 30, and reduce turn-off loss of the semiconductor device 30.

Example embodiments of this application are described above. It should be noted that a person of ordinary skill in the art may further make several improvements and modifications without departing from the principle of this application, and these improvements and modifications are also considered to be within the protection scope of this application.

## Claims

1. A semiconductor device, comprising a drift region, a first electrode structure, and a second electrode structure, wherein the first electrode structure and the second electrode structure are located on a same side of the drift region, the first electrode structure comprises a first insulation layer and a first electrode, the first insulation layer is located on a periphery of the first electrode, the second electrode structure comprises a second insulation layer and a second electrode, the second insulation layer is located on a periphery of the second electrode, and a buffer structure is disposed between the first electrode and the second electrode; and when the semiconductor device is turned on, the buffer structure is configured to increase accumulation of carriers in the drift region.

2. The semiconductor device according to claim 1, wherein the semiconductor device comprises an emitter, the first electrode structure and the second electrode structure are located between the emitter and the drift region and are spaced apart, a first channel structure is disposed between the first electrode structure and the second electrode structure, and the first channel structure is connected between the emitter and the drift region; and when the semiconductor device is turned on, the first channel structure is capable of increasing accumulation of the carriers in the drift region, and the first channel structure, the first insulation layer, and the second insulation layer jointly form the buffer structure.

3. The semiconductor device according to claim 2, wherein the first channel structure comprises a buffer layer and a charge layer that are disposed in a stacked manner, the buffer layer is located between the drift region and the charge layer, the charge layer is a P-type semiconductor, the buffer layer is an N-type semiconductor, and the buffer layer, the first insulation layer, and the second insulation layer jointly form the buffer structure.

4. The semiconductor device according to claim 3, wherein the first channel structure further comprises a contact layer, the contact layer is located between the charge layer and the emitter, an impurity doping concentration of the contact layer is greater than an impurity doping concentration of the charge layer, and the contact layer is in contact with the emitter.

5. The semiconductor device according to claim 4, wherein the first electrode is electrically connected to the emitter, and the second electrode is insulated from the emitter.

6. The semiconductor device according to claim 1, wherein the first electrode structure is in contact with the second electrode structure, and a part of the first insulation layer and a part of the second insulation layer are interconnected together between the first electrode and the second electrode to form the buffer structure.

7. The semiconductor device according to any one of claims 1 to 6, wherein the drift region comprises a top and a bottom that are disposed opposite to each other, both the first electrode structure and the second electrode structure are located on the top, the first electrode structure comprises a first bottom surface, the second electrode structure comprises a second bottom surface, both the first bottom surface and the second bottom surface are connected to the top of the drift region, and a spacing between the first bottom surface and the bottom is less than a spacing between the second bottom surface and the bottom.

8. The semiconductor device according to any one of claims 1 to 6, wherein there are two first electrode structures, the two first electrode structures are spaced apart, the second electrode structures are located between two first electrode structures, there are at least two second electrode structures, a size of the buffer structure in a first direction is less than a spacing between two adjacent second electrode structures, and the first direction is a direction in which the first electrode structure and the second electrode structure are arranged.

9. The semiconductor device according to claim 1, wherein the semiconductor device comprises a floating region, and in a first direction, the floating region, the first electrode, the buffer structure, and the second electrode are arranged in sequence.

10. The semiconductor device according to claim 9, wherein the first electrode structure comprises a first top surface and a first bottom surface that are disposed opposite to each other, the first top surface is disposed away from the drift region, and the floating region covers the first bottom surface.

11. The semiconductor device according to claim 9, wherein the floating region comprises at least two floating portions, the at least two floating portions are spaced apart, a third electrode structure is disposed between adjacent floating portions, the third electrode structure comprises a third insulation layer and a third electrode, and the third insulation layer is located on a periphery of the third electrode.

12. A method for preparing a semiconductor device, comprising:
providing a silicon wafer, wherein the silicon wafer comprises a drift region;
performing etching processing on one side of the drift region to form a first groove and a second groove that are spaced apart;
performing oxidation processing on a wall of the first groove to form a first insulation layer, and performing oxidation processing on a wall of the second groove to form a second insulation layer;
depositing a first electrode in the first groove, wherein the first insulation layer is located on a periphery of the first electrode, and depositing a second electrode in the second groove, wherein the second insulation layer is located on a periphery of the second electrode; and
forming a buffer structure between the first electrode and the second electrode, so that when the semiconductor device is turned on, the buffer structure is configured to increase accumulation of carriers in the drift region.

13. The method for preparing a semiconductor device according to claim 12, wherein in a process of preparing the first insulation layer and the second insulation layer, the first insulation layer and the second insulation layer are spaced apart; and before the forming a first groove and a second groove, the method further comprises: performing ion injection processing on the drift region to inject an N-type impurity so as to form a buffer layer, wherein the buffer layer is located between the first insulation layer and the second insulation layer, and the buffer layer, the first insulation layer, and the second insulation layer jointly form the buffer structure.

14. The method for preparing a semiconductor device according to claim 13, wherein ion injection processing is performed between the first insulation layer and the second insulation layer to inject a P-type impurity so as to form a charge layer, and ion injection processing is performed between the first insulation layer and the second insulation layer to inject a P-type impurity so as to form a contact layer, wherein the charge layer is located between the buffer layer and the contact layer, and a P-type impurity doping concentration of the contact layer is greater than a P-type impurity doping concentration of the charge layer.

15. The method for preparing a semiconductor device according to claim 12, wherein in a process of preparing the first insulation layer and the second insulation layer, the first insulation layer and the second insulation layer are interconnected together to form the buffer structure.

16. The method for preparing a semiconductor device according to claim 15, wherein a spacing between the first groove and the second groove is 0.1 µm to 0.3 µm.

17. An electronic device, comprising a first circuit, a second circuit, and the semiconductor device according to any one of claims 1 to 11, wherein the semiconductor device is electrically connected between the first circuit and the second circuit.
